(19) Europäisches Patentamt
European Patent Office
Office européen des brevets

(11) EP 1 329 437 A2

(12) # DEMANDE DE BREVET EUROPEEN

(43) Date de publication:
**23.07.2003 Bulletin 2003/30**

(51) Int Cl.[7]: **C04B 35/583**, C04B 35/622, C08G 79/08, C01B 21/064

(21) Numéro de dépôt: **03290145.6**

(22) Date de dépôt: **21.01.2003**

(84) Etats contractants désignés:
**AT BE BG CH CY CZ DE DK EE ES FI FR GB GR HU IE IT LI LU MC NL PT SE SI SK TR**
Etats d'extension désignés:
**AL LT LV MK RO**

(30) Priorité: **22.01.2002 FR 0200757**

(71) Demandeur: **EADS Launch Vehicles**
**75781 Paris Cedex 16 (FR)**

(72) Inventeurs:
- **Miele, Philippe**
  **69006 Lyon (FR)**
- **Toury, Bérangère**
  **94130 Nogent sur Marne (FR)**
- **Cornu, David**
  **42300 Roanne (FR)**
- **Bernard, Samuel**
  **69100 Villeurbanne (FR)**
- **Berthet, Marie-Paule**
  **69003 Lyon (FR)**
- **Rousseau, Loic**
  **33160 Saint Aubin de Medoc (FR)**
- **Beauhaire, Guy**
  **78380 Bougival (FR)**

(74) Mandataire: **Audier, Philippe André et al**
**Brevalex,**
**3, rue du Docteur Lancereaux**
**75008 Paris (FR)**

(54) **Procédé de fabrication de fibres de nitrure de bore et fibres obtenues**

(57) La présente invention se rapporte à des fibres de nitrure de bore à haute performance et à un procédé de fabrication de ces fibres.

La présente invention utilise un précurseur borylborazine de formule (I) suivante :

$$[(NHR)_2B(NR)]_3B_3N_3H_3 \qquad (I)$$

dans laquelle R représente un atome d'hydrogène ou un groupe alkyle, cycloalkyle ou aryle, ledit groupe comprenant de 1 à 30 atomes de carbone.

EP 1 329 437 A2

## Description

### DOMAINE TECHNIQUE

La présente invention a pour objet un procédé de fabrication de fibres de nitrure de bore, en particulier de fibres continues de nitrure de bore ayant de bonnes propriétés mécaniques.

De façon plus précise, elle concerne l'obtention de fibres de nitrure de bore à partir d'un précurseur polymère que l'on met en forme par filage pour former des fibres de polymère qui sont soumises ensuite à une céramisation pour les transformer en fibres de nitrure de bore.

Les fibres céramiques de nitrure de bore sont d'un grand intérêt pour la fabrication de matériaux composites ayant de bonnes propriétés de résistance à l'oxydation, de stabilité thermique, et d'isolation électrique.

Pour les matériaux composites, notamment à matrice céramique, il est préférable de disposer de fibres continues pour améliorer la résistance à la fracture de la céramique.

Par ailleurs, il est nécessaire d'utiliser des fibres souples ayant des résistances à la traction élevées.

### ÉTAT DE LA TECHNIQUE ANTERIEURE

Les références entre crochets [ ] renvoient à la liste de références annexée.

Il existe de nombreux procédés de fabrication de nitrure de bore, comme il est décrit par R.T. PAINE et al, **[1]**. Parmi les méthodes décrites dans ce document, on trouve en particulier des procédés utilisant des polymères précurseurs formés à partir de composés inorganiques de bore tels que des borazènes.

Une façon d'obtenir de tels polymères précurseurs a été décrite par C. K. Narula et al **[2].** Elle consiste à faire réagir le trichloroborazine ou le 2-(diméthylamino)-4,6-dichloroborazine avec l'hexa-méthyldisilazane en solution dans le dichlorométhane à température ambiante. Dans le cas où on utilise le 2-(diméthyl-amino)-4,6-dichloroborazine, on favorise la polymérisation en deux points en raison de la présence du groupe $NMe_2$.

Une autre façon d'obtenir des polymères précurseurs décrite dans EP-A-0 342 673 **[3],** consiste à faire réagir un B-tris(alkyl inférieur amino)borazine avec une alkylamine telle que la laurylamine, thermiquement en masse ou en solution.

On peut encore obtenir d'autres polymères précurseurs par polycondensation thermique d'aminoborazines trifonctionnels de formule $[-B(NR^1R^2)-NR^3-]_3$ dans laquelle $R^1$, $R^2$ et $R^3$ qui sont identiques ou différents représentent l'hydrogène, un radical alkyle ou un radical aryle, comme il est décrit dans FR-A-2 695 645 **[4]**.

Les polymères décrits ci-dessus conviennent bien pour l'obtention de poudre ou d'autres formes de nitrure de bore mais il est plus difficile de préparer des formes plus complexes, en particulier des fibres à partir de tels polymères.

Souvent, en effet, l'étirage du polymère précurseur nécessaire à la mise en forme de fibres se fait mal en raison de sa structure réticulée statistique, qui conduit à peu d'allongement, rendant la maîtrise de la section de la fibre très aléatoire. Plus loin, dans le procédé, cela se traduit par des ruptures de fibres ou des points faibles, qui conduisent à des propriétés mécaniques finales très faibles.

Aussi, comme il est indiqué par T. Wideman et al **[5]**, les recherches ont été poursuivies pour trouver d'autres polymères précurseurs convenant mieux pour l'obtention de fibres de nitrure de bore. Dans ce document, il est indiqué qu'un polymère précurseur filable à l'état fondu peut être obtenu en modifiant du polyborazylène par réaction avec une dialkylamine.

Il apparaît donc que de nombreuses voies ont été envisagées pour réaliser des fibres de nitrure de bore, mais sans succès.

Les matériaux obtenus dans l'art antérieur sont des matrices ou du BN massif, mais pas des fibres continues de nitrure de bore de bonne qualité indispensable pour la fabrication de matériaux composites céramiques ayant de bonnes performances mécaniques.

Les polymères utilisés dans l'art antérieur pour préparer les fibres de BN étaient toujours constitués de cycles reliés par des liaisons directes et/ou par des liaisons de type ponts à un atome -N-. Ces polymères sont obtenus à partir d'aminoborazines de formule générale $(NRR')_3B_3N_3R''_3$. De part leur structure, ces polymères sont cependant difficiles à filer.

Actuellement les fibres les plus performantes sont obtenues par polycondensation thermique sous un flux de gaz inerte d'aminoborazines. Cette technique utilise des températures élevées et les vitesses de polymérisation sont relativement lentes.

### EXPOSE DE L'INVENTION

La présente invention a précisément pour but de fournir des fibres de nitrure de bore, continues et tissables,

de haute pureté, présentant des performances élevées et les conservant en vieillissement naturel, obtenues à partir de polymères précurseurs du type polyborylborazines, avec des diamètres adaptés à une utilisation dans des matériaux composites, ainsi qu'un procédé de fabrication de ces fibres. La présente invention a également pour but de fournir des polymères présentant une aptitude au filage supérieure aux polymères décrits dans l'art antérieur.

Les fibres de nitrure de bore de la présente invention sont obtenues en utilisant un précurseur borylborazine de formule (I) suivante :

$$[(NHR)_2B(NR)]_3B_3N_3H_3 \qquad (I)$$

dans laquelle R représente un atome d'hydrogène ou un groupe alkyle, cycloalkyle ou aryle, ledit groupe comprenant de 1 à 30 atomes de carbone.

Selon la présente invention, R peut comprendre, de préférence, de 1 à 10 atomes de carbone, et de préférence encore de 1 à 6 atomes de carbone.

Selon l'invention, R peut être choisi par exemple dans le groupe constitué de méthyle, éthyle, propyle, isopropyle, butyle, isobutyle, pentyle, isopentyle, hexyle ou isohexyle.

Les précurseurs borylborazines de formule (I) de la présente invention permettent l'obtention de polymères constitués de cycles reliés entre eux par des ponts intercycliques à trois atomes de type N-B-N originaux dont les caractéristiques répondent à celles énoncées pour les meilleurs polymères précurseurs de fibres de nitrure de bore. Cette structure apporte une grande souplesse au polymère qui peut alors être mis en forme de fil très facilement.

Ces précurseurs peuvent être obtenus par exemple en une étape à partir de trichloroborazine $Cl_3B_3N_3H_3$ et d'un aminoborane $B(NHR)_3$ en proportions respectives 1/3 en présence d'un excès de triéthylamine $Et_3N$ par rapport au nombre de moles d'atome de chlore. Cet excès permet de piéger le chlorure d'hydrogène formé sous forme de chlorhydrate de triéthylamine solide. Après évaporation de la phase liquide, le précurseur (I) peut être récupéré par évaporation du solvant.

Le nombre important d'atomes de carbone dans les précurseurs borylborazine de formule (I) comparés au aminoborazines de l'art antérieur pourrait apparaître comme un inconvénient pour le rendement de céramisation que l'on souhaite le plus élevé possible. Cependant, les inventeurs ont noté que, de manière inattendue, il procure une bonne filabilité au polymère. De plus, selon l'invention, le passage de précurseur comportant peu d'atomes de carbones, tel que R = $CH_3$, à un précurseur ayant un nombre d'atomes de carbone plus important, par exemple avec R = iPr, permet avantageusement de mieux contrôler la vitesse de polycondensation pour obtenir un polymère de viscosité adaptée à son filage.

Dans le cas R = iPr, le rendement céramique diminue mais la combinaison rendement céramique/aptitude au filage propose un bon compromis permettant d'obtenir in-fine des fibres de nitrure de bore de hautes performances mécaniques.

A titre d'exemple de précurseurs borylborazines utilisables selon la présente invention, on peut citer le tri (isopropylaminoboryl)borazine de formule (II) et le tri(méthylaminoboryl)borazine de formule (III) suivantes :

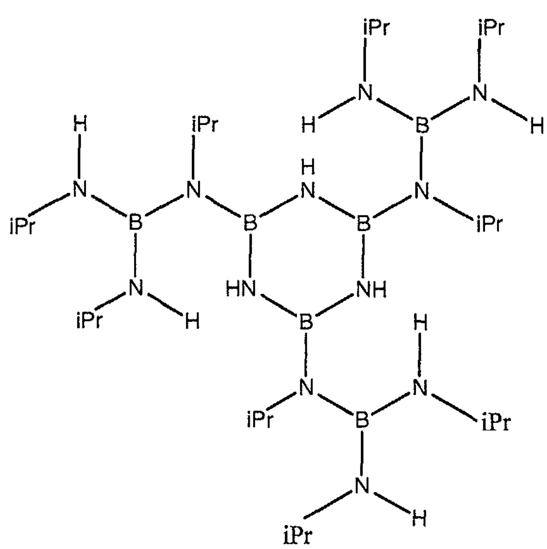

(II)

dans laquelle iPr est un groupe isopropyle.

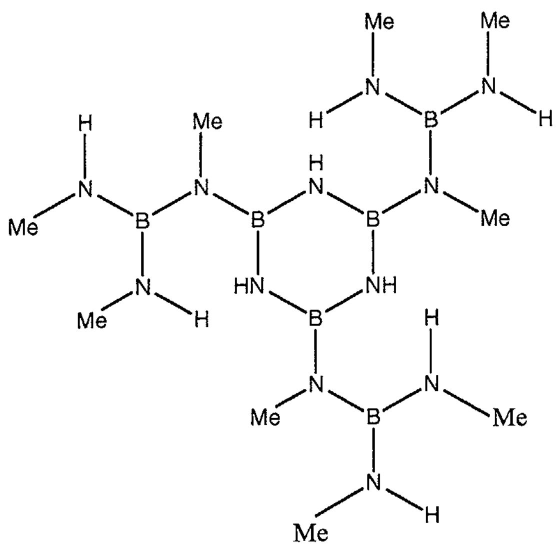

(III)

dans laquelle Me est un groupe méthyle.

Les fibres de nitrure de bore de la présente invention sont avantageusement obtenues par le procédé de la présente invention comprenant les étapes suivantes :

a) polycondensation thermique, sous une pression inférieure à $10^5$ Pa, d'un précurseur borylborazine de formule (I) décrite ci-dessus, pour obtenir un polymère,
b) filage du polymère obtenu à l'étape a) pour obtenir des fibres dudit polymère, et
c) traitement thermique de céramisation des fibres obtenues à l'étape b) pour obtenir des fibres céramiques de nitrure de bore.

Selon l'invention, l'étape de polycondensation thermique est réalisée à une pression inférieure à $10^5$Pa, c'est à dire à pression réduite. Ceci permet avantageusement d'éliminer l'aminoborane co-produit de la polycondensation au fur et à mesure de sa formation. En effet, dans le cas contraire, cet aminoborane peut engendrer des réactions secondaires de polycondensation et/ou d'autopolymérisation néfastes pour le contrôle de la vitesse de polycondensation et de la nature du polymère. La pression peut être supérieure ou égale à 10 Pa.

De plus, le fait que le procédé de la présente invention soit réalisé sous pression réduite permet également de récupérer très facilement les produits issus de la polycondensation et donc de les recycler.

Enfin, l'utilisation d'une pression réduite permet d'augmenter la vitesse de la réaction de polycondensation et donc de réduire la durée de cette étape.

La pression peut par exemple être de 10 à $10^2$ Pa.

Selon l'invention, l'étape a) de polycondensation thermique peut avantageusement être réalisée à une température de 30 à 150°C, par exemple de 50 à 150°C.

Selon l'invention, il est possible d'agir sur les propriétés mécaniques et structurales finales des fibres de nitrure de bore en contrôlant le degré de polymérisation du polymère précurseur.

Aussi, de manière avantageuse, selon la présente invention, la polymérisation du borylborazine est réalisée de façon telle que le taux de polymérisation du polymère précurseur, soit le nombre de moles d'atomes de bore dégagé sous forme d'aminoborane $B(NHR)_3$ par mole de borylborazine, soit supérieur ou égal à 1, de préférence de 1 à 2, de préférence encore d'environ 1,4.

En choisissant le taux de polymérisation dans cette gamme, on obtient un polymère précurseur ayant une température de transition vitreuse Tg de 30 à 100°C, de préférence de 20 à 50°C, que l'on peut transformer par filage et céramisation en fibres de nitrure de bore ayant les propriétés mécaniques souhaitées.

Le taux de polymérisation peut être réglé en choisissant la température de fin de polymérisation et la durée de polymérisation.

Généralement, la température de fin de polymérisation est de 180 à 200°C, de préférence de 130 à 150°C.

La durée de la polymérisation est fonction de la masse de monomère à polycondenser.

Selon l'invention, l'étape de filage s'effectue généralement sous atmosphère contrôlée et on a remarqué qu'il était préférable de maintenir le taux d'humidité relatif de cette atmosphère à une valeur inférieure à 10 % et de préférence inférieure à 2 %.

On peut extruder le polymère par une filière de 50 à 500 μm et plus particulièrement de 100 à 200 μm, qui est surmontée d'un filtre et d'un élément de cisaillement. L'étirage du fil polymérique se fait à l'aide d'une bobine réfractaire de diamètre compris entre 50 et 200 mm, et plus précisément de 50 à 100 mm. Cette bobine peut être par exemple en graphite.

Pour obtenir de bons résultats, de préférence, le filage est réalisé à une température de filage Tf telle que 70°C ≤ Tf - Tg ≤ 155°C, de préférence telle que 80°C ≤ Tf - Tg ≤ 110°C. Le filage à des températures inférieures à 155°C est possible grâce aux précurseurs de la présente invention. Tf peut être inférieure à la température de fin de polymérisation.

Selon la présente invention, le traitement de céramisation peut être effectué par les méthodes classiques généralement utilisées pour la transformation des fibres de polymères précurseurs à base d' aminoborazines en nitrure de bore, en les soumettant à un traitement thermique en présence d'ammoniac, puis d'azote et éventuellement d'un gaz inerte tel que l'argon.

Selon l'invention, un traitement céramique adapté au type de polymère utilisé selon la présente invention, par exemple suivant R = Me ou iPr, permet de convertir les fils polymériques en fibres de BN. De part leur structure, les polymères issus des précurseurs borylborazine utilisés pour la réalisation de fibres de nitrure de bore selon la présente invention possèdent une température de transition vitreuse et aussi une température de filage plus faibles que les produits de l'art antérieur.

De préférence, on réalise la céramisation en deux étapes, en réalisant une première étape de précéramisation avec l'ammoniac jusqu'à une température inférieure ou égale à 1000°C, de préférence de 400 à 600°C, et mieux encore de 500 à 600°C, puis on effectue une étape de céramisation en atmosphère d'azote et/ou de gaz rare à des températures supérieures, par exemple de 1400 à 2200°C, en une ou plusieurs opérations successives.

Pour ces traitements, on peut utiliser une rampe de chauffage qui permet d'augmenter la température à une vitesse de 5 à 1000°C/h, de préférence de 15 à 700°C/h.

Selon l'invention, la fibre de nitrure de bore à haute performance obtenue à partir des borylborazines est une fibre continue et tissable de nitrure de bore hexagonal, sous forme de monofilament ou de mèche de filaments, et le (s) filament(s) présentent une contrainte médiane à la rupture $\sigma_R$ d'au moins 700 MPa, de préférence de 900 à 2000 MPa, un module d'Young moyen E de 50 à 250 GPa, de préférence de 50 à 200 GPa et une distribution des allongements à la rupture moyens $\varepsilon_R$ de 0,2 à 2%, et de préférence de 0,2 à 1%.

On précise que la contrainte à rupture $\sigma_R$ est déterminée sur une cinquantaine de filaments en longueur d'éprouvette de 1 cm. Les tests de rupture sont analysés par le modèle de Weibull où les contraintes à rupture sont déterminées pour une probabilité de rupture égale à 0,63. On définit une valeur moyenne de la distribution des allongements à la rupture moyens ($\varepsilon_R$) et à partir de cette valeur, on calcule la valeur médiane de la distribution des contraintes à rupture médianes ($\sigma_R$) à une probabilité de survie de 0,37. On peut alors en déduire le module d'Young ou d'élasticité E.

Selon l'invention, le diamètre du ou des filaments constituant la fibre est de préférence 4 à 25 μm.

Le nitrure de bore formant les fibres est du nitrure de bore hexagonal. Cette structure correspond à un empilement de plans hexagonaux de BN. Une telle structure est décrite par exemple dans la demande FR-A-2 806 422.

Selon l'invention, la fibre présente avantageusement un taux d'impuretés inférieur à 1 %, en particulier elle contient moins de 0,1 % en poids au total d'éléments de numéro atomique supérieur à 11, et présente une masse volumique égale ou supérieure à 1,8 $g/cm^3$.

Par ailleurs, la fibre conserve ses performances élevées en vieillissement naturel. En effet, en vieillissement accéléré, à 65°C, dans une atmosphère à 75 % d'humidité relative, on ne dénote aucune diminution mesurable des propriétés mécaniques au bout de deux mois.

Les fibres de la présente invention présentent une excellente filabilité et permettent par conséquent un filage facile, alors qu'avec les polymères de l'art antérieur cette étape est très délicate.

Les fibres obtenues selon la présente invention sont des fibres de haute performance. Le polymère précurseur des fibres de la présente invention présente un compromis idéal entre filabilité et rendement céramique, c'est à dire qu'il contient à la fois de longues chaînes linéaires et des cycles pour limiter les réactions de réversion.

Par ailleurs, le procédé de synthèse des polymères et des fibres de la présente invention présente un gain de temps et d'énergie importants pour une production industrielle.

Les applications industrielles de la présente invention sont nombreuses, parmi elles ont peut citer, à titre d'exemple, la fabrication de revêtement protecteurs contre l'oxydation, de mousses de nitrure de bore, de matériaux composites BN/C ou BN/BN, de puits de chaleur pour la microélectronique, la réalisation de pièces thermostructurales ou de radômes d'antennes, etc.

D'autres caractéristiques et avantages de l'invention apparaîtront mieux à la lecture des exemples suivants,

donnés bien entendu à titre illustratif et non limitatif.

## EXEMPLES

### EXEMPLE 1 : SYNTHESE DES PRECURSEURS BORYLBORAZINES

Dans cet exemple, les inventeurs décrivent la synthèse de deux précurseurs (monomères) borylborazine qui sont le tri(isopropylaminoboryl)borazine (formule(II)) et le tri(méthylaminoboryl)borazine (formule(III)). Comparé au précurseur (II), le précurseur (III) contient peu de carbone ce qui permet d'accroître son rendement céramique.

A) SYNTHESE DU PRECURSEUR (II)

Il a été obtenu par réaction, dans le toluène, d'un mélange de trois équivalents de tris(isopropylamino)borane sur un équivalent de trichloroborazine. La synthèse a été réalisée en présence de triéthylamine, utilisée pour précipiter sous forme de chlorhydrate de triéthylamine le chlorure d'hydrogène libéré par la réaction.

Le trichloroborazine a été obtenu par réaction du trichlorure de bore ($BCl_3$) sur du chlorure d'ammonium ($NH_4Cl$). Le tris(isopropylamino)borane a été obtenu par réaction du trichlorure de bore ($BCl_3$) sur un gros excès (supérieur à 6 fois) d'isopropylamine primaire ($NH_2iPr$).

On a introduit le tris(isopropylamino)borane dans la solution de trichloroborazine en présence de triéthylamine dans un réacteur en atmosphère inerte (argon), et on a soumis le mélange à une agitation de type magnétique.

Après l'addition à -10°C, le mélange réactionnel a été ramené à température ambiante et laissé sous agitation 24 heures.

La solution a alors été filtrée sous argon. On a récupéré d'une part le résidu chlorhydrate de triéthylamine, d'autre part le filtrat qui a été évaporé sous vide. On a récupéré un liquide visqueux jaune contenant 10% en masse environ de solvant.

A la fin de la polycondensation thermique, on a déterminé le dégagement d'aminoborane par différence de pesée entre le polymère et le monomère sec de départ en tenant compte de la proportion de toluène présente au début.

Le schéma réactionnel ci-dessous résume les réactions chimiques mises en jeu.

Le polymère obtenu a été identifié comme étant un polyborylborazine présentant une température de transition vitreuse Tg de 60°C en calorimétrie différentielle à balayage (DSC). Après traitement thermique jusqu'à 1000°C, ce polymère avait une perte de masse de 64,3 %.

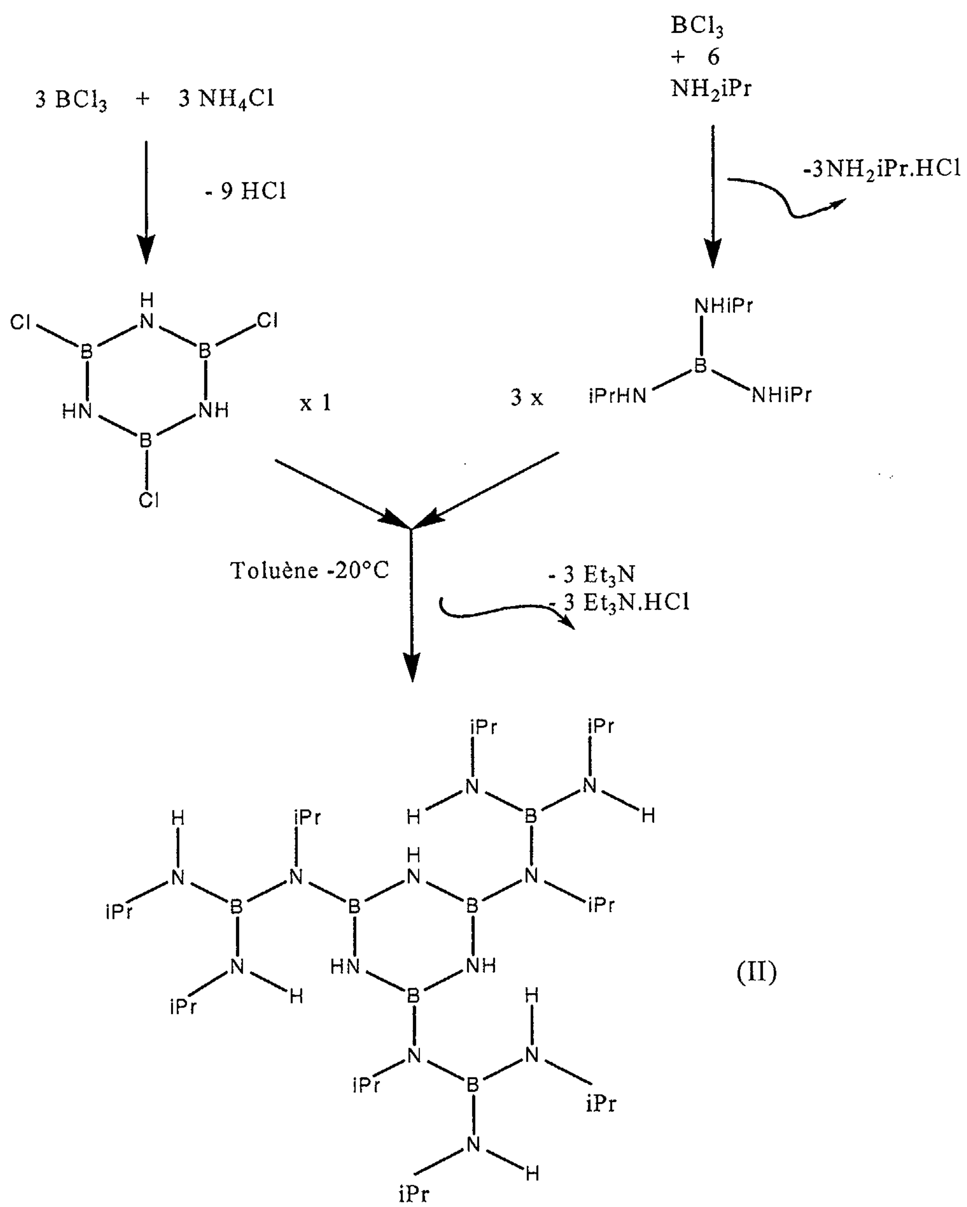


(II)

Synthèse du précurseur (II)

B) SYNTHESE DU PRECURSEUR (III)

On a procédé de la même manière que pour la synthèse du précurseur (II), en remplaçant le tris(isopropylamino)borane par du tris(méthylamino)borane.

Le polymère obtenu a été identifié comme un polyborylborazine présentant une température de transition vitreuse Tg de 50°C en calorimétrie différentielle à balayage (DSC). Après traitement thermique jusqu'à 1000°C, ce polymère avait une perte de masse de 52,8 %.

Dans les synthèses du précurseur (II) et du précurseur (III), tous les produits finaux et intermédiaires ont été caractérisés par RMN multinoyaux, et les spectres présentaient bien les signaux des produits attendus.

**EXEMPLE 2 : POLYCONDENSATION DU PRECUSEUR (II) ET CARACTERISTIQUES DU POLYMERE DERIVE**

La polycondensation du précurseur (II) obtenu de la manière décrite dans l'exemple 1 conduit à la formation d'un polymère et à la libération de $B(NHiPr)_3$. Cette espèce peut engendrer des réactions secondaires, il est donc important de réaliser la montée en température sous vide pour retirer l'aminoborane au fur et à mesure de sa formation.

Deux mécanismes de polycondensation ont été envisagés. Ces mécanismes sont schématisés ci-dessous.

Le premier mécanisme α) conduit à la formation d'un pont à trois atomes entre les cycles boraziniques. Le second mécanisme β), permet la création d'une liaison intercyclique. Les analyses RMN ont montrées que le premier mécanisme α) est majoritaire, mais que le mécanisme β) ne peut pas être exclu. De plus, le fait que les groupements boryle soient très encombrants va également dans ce sens. En effet, les protons cycliques sont plus difficiles à atteindre par un groupement boryle.

*Mécanisme α)*

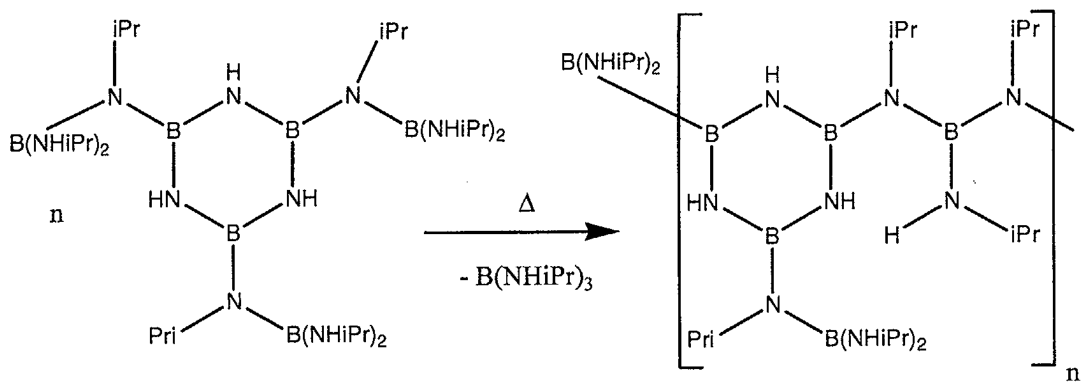


*Mécanisme β)*

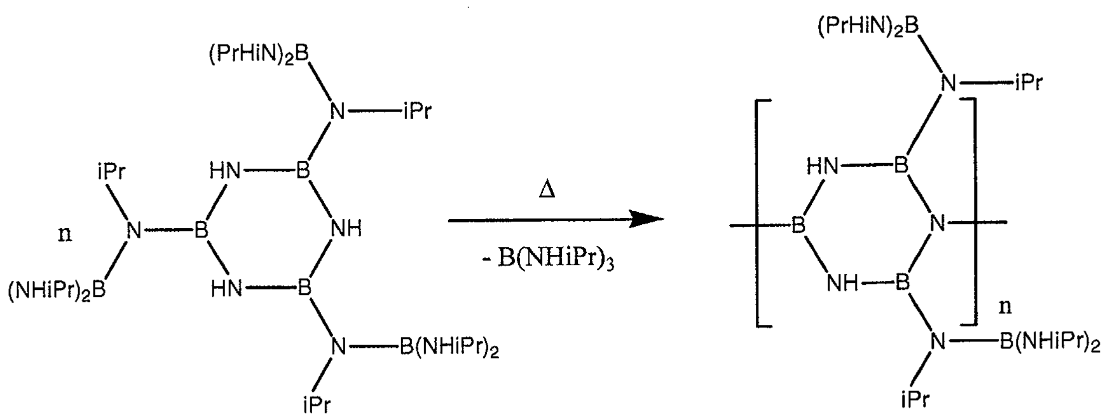


La polymérisation a été réalisée dans un réacteur en verre avec une agitation mécanique, une des sorties du réacteur est reliée à un piège plongé dans l'air liquide, lui-même relié au vide (10 Pa). Le programme de température utilisé est exposé ci-dessous.

Masse de monomère = 11,9g (dont 10% en masse de toluène)

Programme de température = T=20°C (45min.)

T=30°C (30min.)

T=70°C (2h00)

T=90°C (1h00)

T=100°C (1h30)

T=120°C (2h15)

T=140°C (30min.)

T=150°C (1h30)

Remarque : la température a été montée arbitrairement jusqu'à 120°C, puis augmentée lorsque que le polymère est devenu assez visqueux.

Masse de monomère sec obtenu : 10,7g (17,01mmol)
Masse de polymère : 5,7g
Masse d'aminoborane libéré : 5g (27,06mmol)

Le tris(isopropylamino)borane formé et récupéré dans le piège a été analysé et caractérisé par RMN 1H.
Le taux d'avancement du polymère ($n_{am}/n_{mono}$, avec n le nombre de moles) est de 1,5. Ceci correspond à un polymère très avancé.
La température de transition vitreuse de ce polymère est de l'ordre de 60°C.

**EXEMPLE 3 : POLYCONDENSATION DU PRECURSEUR (III) ET CARACTERISTIQUES DU POLYMERE DERIVE.**

La polycondensation du précurseur (III) conduit, de la même façon que celle du précurseur (II), à la formation d'un polymère et à la libération de $B(NHMe)_3$.
Pour les mêmes raisons que celles précédemment exposées, la polycondensation a été effectuée sous vide.
La caractérisation par RMN multinoyaux a indiqué, là aussi, que le polymère est constitué de cycles majoritairement reliés par des liaisons pontées.
En revanche, le contrôle de la polycondensation est beaucoup plus difficile dans ce second cas, car les groupements méthylaminoboryle présentent une très grande réactivité. De ce fait, ils réagissent très rapidement les uns avec les autres et le temps de polycondensation devient donc très court.
Après 45 minutes de chauffage graduel jusqu'à 130°C, le produit est devenu solide.
Le polymère s'est présenté sous la forme d'un solide blanc poudreux ayant les caractéristiques suivantes :

Masse de monomère :6,5g (dont 10% en masse de toluène)
Masse de monomère sec : 5,9g (15,7 mmol)
Masse de polymère : 4,0g
Masse d'aminoborane libéré : 1,9g (18,8mmol)

Le tris(méthylamino)borane formé et récupéré dans le piège a été analysé et caractérisé par RMN$^1$H.
L'avancement du polymère ($n_{am}/n_{mono}$) est de 1,2.
La température de transition vitreuse de ce polymère est de l'ordre de 50°C.

**EXEMPLE 4 : FILAGE DU POLYMERE DERIVE DU PRECURSEUR (II), OBTENTION DE FIBRES DE NITRURE DE BORE (BN)**

Dans les exemples suivants, les fibres obtenues ont été caractérisées en spectrométrie Raman et en analyse chimique par spectroscopie électronique (ESCA) comme étant bien des fibres de nitrure de bore hexagonal exemptes de carbone. On a déterminé ensuite leur diamètre, leurs propriétés mécaniques et leur structures.
Les diamètres sont évalués par la méthode d'interférométrie laser en utilisant l'approximation de Fraunhofer. Ce sont les monofilaments qui jouent le rôle de fente de diffraction. La technique consiste à mesurer la distance entre deux franges d'interférence consécutives en connaissant la longueur d'onde du laser et la distance du monofilament

à l'écran de mesure.

Les propriétés mécaniques sont déterminées à l'aide d'une machine de microtraction. Les cadres sur carton sont disposés dans les mors de telle sorte que l'essai corresponde à la traction du monofilament. Une force de traction est appliquée sur le monofilament. Les essais sont réalisés sur une cinquantaine de monofilaments en longueur d'éprouvette de 1 cm. Les tests de rupture sur ces filaments sont réalisés par le modèle de Weibull où les contraintes à rupture sont déterminées pour une probabilité de rupture égale à 0,63. On définit une valeur moyenne de la distribution des allongements à la rupture ($\varepsilon_R$) et à partir de cette valeur, on calcule la valeur médiane de la distribution des contraintes à rupture ($\sigma_R$) à une probabilité de survie de 0,63. On peut alors en déduire le module d'Young ou d'élasticité E.

L'état structural des filaments est déterminé par diffraction des rayons X et diffusion Raman. La largeur à mi-hauteur de la raie de diffraction X (002) qui se situe à une valeur 2 θ de 26,765° pour le nitrure de bore hexagonal, apporte une information sur la cristallinité du filament suivant l'axe c.

Le polymère a été filé sur FILAMAT (marque de commerce) de la société PRODEMAT avec une filière de 200µm à une température de 151°C, en l'extrudant à une vitesse de 0,85 à 1,4 mm/min sous une force variant de 20 à 40 daN et en l'enroulant autour d'une bobine de graphite de 50 et 100mm de diamètre à une vitesse d'étirage de 140 à 220 cm/s.

On réalise ensuite le traitement de précéramisation sous ammoniac jusqu'à au moins 600°C en vue d'éliminer les groupements méthyle du polymère de départ, puis sous azote jusqu'à 1800°C.

Les traitements thermiques de précéramisation et de céramisation effectués sont respectivement les suivants :

<u>Traitement thermique :</u>

a) Précéramisation : chauffage jusqu'à 600°C, à une vitesse de 25°C/h, sous $NH_3$.

b) Céramisation :

- Chauffage de 600 à 1100°C, à une vitesse de 100°C/h, sous $N_2$.
- Maintien à 1100°C, sous $N_2$, pendant 90 minutes.
- Refroidissement à la température ambiante.
- Chauffage jusqu'à 1400°C, à une vitesse de 600°C/h, sous $N_2$.
- Maintien à 1400°C, sous $N_2$, pendant 1 heure.
- Chauffage de 1400 à 1600°C, à une vitesse de 600°C/h, sous $N_2$.
- Maintien à 1600°C, sous $N_2$ pendant 1 heure.
- Chauffage de 1600 à 1800°C, à une vitesse de 600°C/h, sous $N_2$.
- Maintien à 1800°C, sous $N_2$, pendant 1 heure.

Le traitement s'effectue sous tension mécanique par retrait du polymère sur la bobine réfractaire lors de la montée en température. L'intérêt de poursuivre le traitement jusqu'à 1800°C est de cristalliser le nitrure de bore et d'orienterles cristaux de BN parallèlement à l'axe de la fibre.

On refroidit alors les fibres jusqu'à la température ambiante et on les caractérise mécaniquement et structurallement. Elles ont un aspect blanc et sont légèrement détendues autour de la bobine.

Les résultats des tests de traction obtenus sur les différents échantillons réalisés sont récapitulés dans le tableau I ci-dessous.

Dans ce tableau, V représente : vitesse de bobinage, Φ : diamètre des fibres, $\sigma_R$ : la containte à la rupture, et E : le module d'élasticité.

La forte diminution du diamètre des fibres lorsque l'on passe du fil polymérique au matériau céramique est dû au rendement céramique faible du polymère (environ 27%).

Les analyses par diffraction des rayons X et spectroscopie de diffusion Raman ont confirmé l'obtention de nitrure de bore bien cristallisé.

Tableau I

| | **1** | **2** | **3** | **4** |
|---|---|---|---|---|
| **Bobine (mm)** | 100 | 100 | 50 | 50 |
| **$V_{bobinage}$ (cm/s)** | 160 | 160 | 145 | 200 |

Tableau I (suite)

| | 1 | 2 | 3 | 4 |
|---|---|---|---|---|
| **$V_{piston}$ (mm/min)** | 0,85 | 0,85 | 0,8-1 | 1,2-1,4 |
| **$\phi_{th}$ crues (μm)** | 28,4 | 28,4 | 29-32,4 | 30-32,6 |
| **φ céramisées (μm)** | 8,4 | 7,4 | 10,5 | 11,0 |
| **$\sigma_R$ (MPa)** | 910 | 950 | 1130 | 910 |
| **E (Gpa)** | 163 | 195 | 195 | 168 |

**EXEMPLE 5 : FILAGE DU POLYLYMERE DERIVE DU PRECURSEUR (III), OBTENTION DE FIBRES DE NITRURE DE BORE (BN)**

Le protocole est celui utilisé dans l'exemple 4.

Le polymère a été filé sur FILAMAT (marque de commerce) de la société PRODEMAT, avec une filière de 200μm sur une bobine de 100mm.

Température de filage = 138°C

Les traitements thermiques de précéramisation et de céramisation effectués sont ceux décrits dans l'exemple précédent.

Les polymères de la présente invention, issus des deux précurseurs (II) et (III) préparés, présentent très nettement des aptitudes améliorées au filage par rapport aux polymères de l'art antérieur.

Par exemple, les valeurs des propriétés mécaniques des fibres issues notamment du précurseur (II) permettent aisément de faire de ce polymère un produit de choix pour la production de fibres de BN.

Alors que les fibres d'aminoborazines de l'art antérieur présentent les inconvénients d'un rendement céramique faible et d'un mauvais contrôle du taux d'avancement, la présente invention présente de nombreux avantages par rapport à cet art antérieur. Ces avantages sont notamment les suivants :

- une structure pontée à 3 atomes de type N-B-N correspondant à celle d'un précurseur idéal de fibres de nitrure de bore,
- une durée et une température de polycondensation plus faibles,
- une polycondensation sous vide permettant un recyclage de l'aminoborane,
- une plus faible température de filage.

**LISTE DE REFERENCES**

**[1] :** R.T. PAINE et al, Chem. Rev., 90, 1990, pp. 73-91.

**[2] :** C. K. Narula et al dans Chem. Mater, 2, 1990, pp. 384-389.

**[3]** : EP-A-0 342 673.

**[4]** : FR-A-2 695 645.

**[5]** : T. Wideman et al, Chem. Mater., 10, 1998, pp. 412-421.


**Revendications**

1. Utilisation d'un précurseur borylborazine de formule (I) suivante :

$$[(NHR)_2B(NR)]_3B_3N_3H_3 \qquad (I)$$

dans laquelle R représente un atome d'hydrogène ou un groupe alkyle, cycloalkyle ou aryle, ledit groupe comprenant de 1 à 30 atomes de carbone,

pour la fabrication de fibres de nitrure de bore.

**2.** Utilisation selon la revendication 1, dans laquelle R est choisi dans le groupe constitué de méthyle, éthyle, propyle, isopropyle, butyle, isobutyle, pentyle, isopentyle, hexyle ou isohexyle.

**3.** Utilisation selon la revendication 1, dans laquelle le précurseur borylborazine est le tri(isopropylaminoboryl)borazine de formule (II) ou le tri(méthylaminoboryl)borazine de formule (III) suivantes :

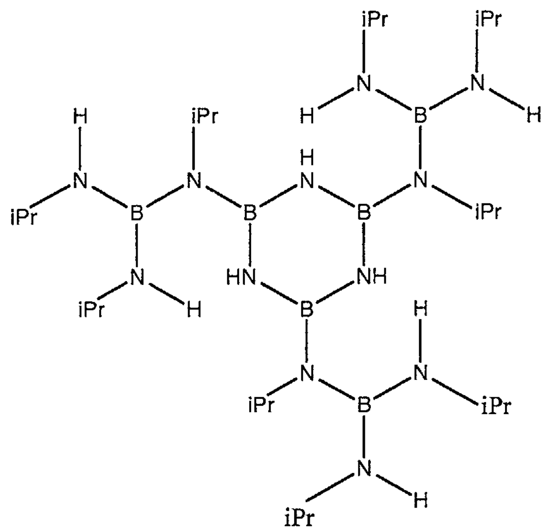

(II)

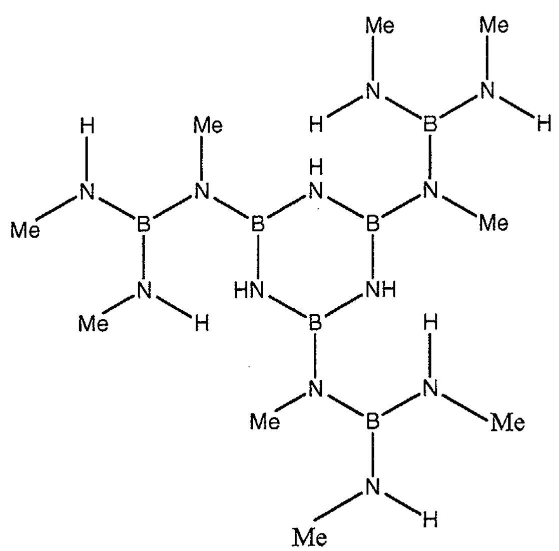

(III)

iPr étant un groupe isopropyle et Me étant un groupe méthyle.

**4.** Procédé de fabrication de fibres de nitrure de bore comprenant les étapes suivantes :

a) polycondensation thermique, sous une pression inférieure à $10^5$ Pa, d'un précurseur borylborazine de formule (I) suivante :

$$[(NHR)_2B(NR)]_3B_3N_3H_3 \qquad (I),$$

dans laquelle R représente un atome d'hydrogène ou un groupe alkyle, cycloalkyle ou aryle, ledit groupe comprenant de 1 à 30 atomes de carbone, pour obtenir un polymère,

b) filage du polymère obtenu à l'étape a) pour obtenir des fibres dudit polymère, et

c) traitement thermique de céramisation des fibres obtenues à l'étape b) pour obtenir des fibres céramiques de nitrure de bore.

**5.** Procédé selon la revendication 4, dans lequel R est choisi dans le groupe constitué de méthyle, éthyle, propyle, isopropyle, butyle, isobutyle, pentyle, isopentyle, hexyle ou isohexyle.

**6.** Procédé selon la revendication 4, dans lequel l'étape a) de polycondensation thermique est réalisée à une pression supérieure ou égale à 10 Pa.

**7.** Procédé selon la revendication 4, 5 ou 6, dans lequel l'étape a) de polycondensation thermique est réalisée à une température de 30 à 150°C.

**8.** Procédé selon la revendication 4, dans lequel le taux de polymérisation est supérieur à 1.

**9.** Procédé selon la revendication 4, dans lequel le taux de polymérisation est de 1 à 2.

**10.** Procédé selon la revendication 4, dans lequel on effectue le filage à une température de filage Tf telle que 70°C ≤ Tf - Tg < 150°C, avec Tf la température de filage et Tg la température de transition vitreuse du polymère.

**11.** Procédé selon la revendication 10, dans lequel la température de filage Tf est inférieure à la température de fin de polymérisation.

**12.** Procédé selon la revendication 4, dans lequel le précurseur borylborazine est le tri(isopropylaminoboryl)borazine de formule (II) ou le tri(méthylaminoboryl)borazine de formule (III) suivantes :

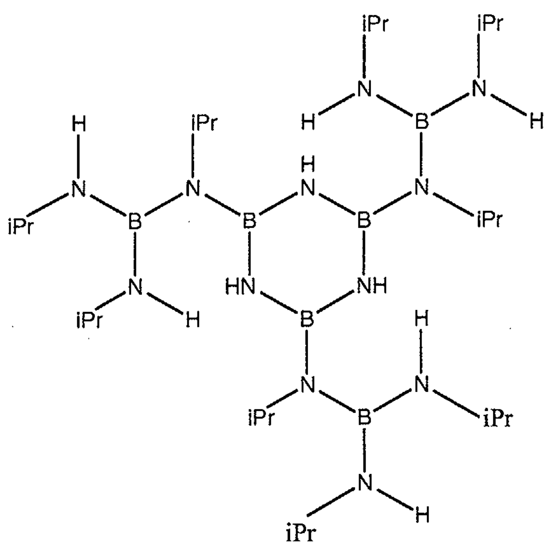

(II)

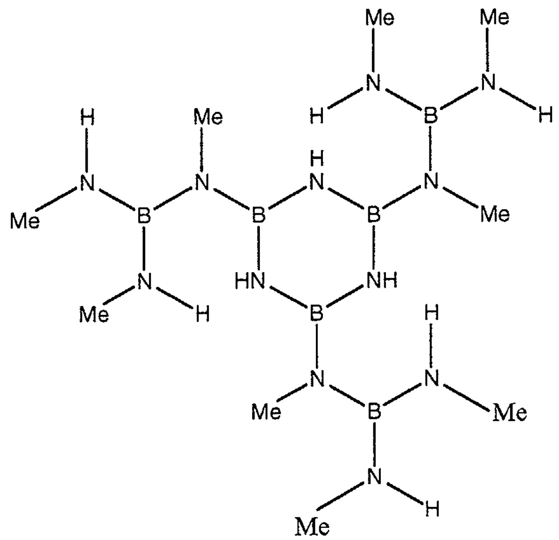

(III)

iPr étant un groupe isopropyle et Me étant un groupe méthyle.

**13.** Procédé selon la revendication 4, dans lequel on effectue le filage dans une atmosphère ayant un taux d'humidité inférieur à 10 %, de préférence inférieur à 2 %.

**14.** Procédé selon la revendication 4, dans lequel l'étape c) de céramisation est réalisé en deux étapes, en réalisant une première étape de précéramisation avec de l'ammoniac jusqu'à une température inférieure ou égale à 1000°C, puis en réalisant une deuxième étape de céramisation en atmosphère d'azote et/ou de gaz rare à des températures supérieures, notamment de 1400 à 2200°C, en une ou plusieurs opérations successives.

**15.** Fibre de nitrure de bore obtenue par un procédé selon l'une quelconque des revendications 4 à 14 précédentes.

**16.** Utilisation d'un procédé de fabrication de fibres de nitrure de bore selon l'une quelconque des revendications 4 à 14 précédentes pour la fabrication de revêtement protecteurs contre l'oxydation, de mousses de nitrure de bore, de matériaux composites BN/C ou BN/BN ou de puits de chaleur pour la microélectronique.

**17.** Utilisation de fibres de nitrure de bore selon la revendication 15, pour la fabrication de revêtement protecteurs contre l'oxydation, de mousses de nitrure de bore, de matériaux composites BN/C ou BN/BN ou de puits de chaleur pour la microélectronique.